(19) Europäisches Patentamt / European Patent Office / Office européen des brevets

(11) **EP 4 683 152 A1**

(12) **EUROPEAN PATENT APPLICATION**
published in accordance with Art. 153(4) EPC

(43) Date of publication:
**21.01.2026 Bulletin 2026/04**

(21) Application number: **23928764.2**

(22) Date of filing: **15.11.2023**

(51) International Patent Classification (IPC):
*H02J 3/00* (2026.01)    *H02J 3/38* (2026.01)
*H02J 13/00* (2026.01)

(52) Cooperative Patent Classification (CPC):
**H02J 3/00; H02J 3/38; H02J 13/00**

(86) International application number:
**PCT/JP2023/041112**

(87) International publication number:
**WO 2024/195195 (26.09.2024 Gazette 2024/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.03.2023 JP 2023043356**

(71) Applicant: **HITACHI, LTD.**
**Chiyoda-ku**
**Tokyo 100-8280 (JP)**

(72) Inventor: **PANDEY, Ravikant**
**Tokyo 100-8280 (JP)**

(74) Representative: **Mewburn Ellis LLP**
**Aurora Building**
**Counterslip**
**Bristol BS1 6BX (GB)**

(54) **POWER LINE MANAGEMENT SYSTEM AND POWER LINE MANAGEMENT METHOD**

(57) In view of instability of a power line due to expansion of introduction of RES, in order to evaluate stability of the power line and suppress occurrence of an oscillation such as an SSO, a power line management system includes: a storage unit which stores power load prediction information indicating prediction of a power load in the power line and power generation prediction information indicating prediction of power generated by a power plant in the power line; an index calculation unit which calculates stability index information indicating a stability index for evaluating stability of the power line on the basis of the power load prediction information and the power generation prediction information; a power information acquisition unit which acquires power load information indicating an actual power load in the power line and power generation information indicating power actually generated by a power plant in the power line from the power line via the communication network; and a stability evaluation unit which calculates a stability score related to the power line on the basis of the power load information and the power generation information, and generates a stability evaluation result indicating the stability of the power line on the basis of the stability score and the stability index information.

[FIG. 2]

FIG. 2

**Description**

Technical Field

The present invention relates to a power line management system and a power line management method.

Background Art

In recent years, as demand for clean energy increases, introduction of renewable energy systems (RES) into power lines is expanding. Since the amount of power generated by RES varies due to various causes such as sunshine hours and wind direction, the supply to the power line easily becomes unstable. For this reason, with the spread of RES, there is a concern regarding the stability of the power line.
Conventionally, proposals have been made for the purpose of monitoring the stability of the power line.
For example, US 10855079 (PTL 1) discloses a technology that "A method for operating a renewable energy power system connected to a power grid includes operating the renewable energy power system at one or more first operational settings. The method also includes monitoring the renewable energy power system for electrical oscillations caused by a grid or system disturbance. In response to detecting the electrical oscillations being above a predetermined threshold indicative of the one or more first operational settings no longer being suitable for grid conditions, the method includes changing the one or more first operational settings to one or more different, second operational settings so as to reduce the electrical oscillations in the renewable energy power system."

Citation List

Patent Literature

PTL 1: US 10855079

Summary of Invention

Technical Problem

PTL 1 describes a means for stabilizing a power line by monitoring an oscillation in the power line, and, when an oscillation indicating that the current operation setting of RES is not suitable for the state of the power line is detected, changing the operation setting of RES to suppress the oscillation.
However, in the means described in PTL 1, the change of the operation setting of RES for stabilizing the power line is performed after an oscillation such as a sub-synchronous oscillation (SSO) is detected, that is, after the power line is already unstable, and thus there is a possibility that equipment such as a transmission line and a transformer in the power line is damaged by the oscillation.
In view of the instability of the power line due to the expansion of the introduction of RES described above, there is a need for a means for evaluating the stability of the power line and suppressing the occurrence of the oscillation such as the SSO.
In this regard, an object of the present disclosure is to provide a power line management means capable of suppressing occurrence of an oscillation such as a SSO and securing stability of a power line by comparing, for each bus in the power line, a stability score, which is obtained on the basis of power related to a power electronics system (PES) leading to instability of the power line and total power related to the bus, with a predetermined stability index, evaluating stability of the power line, and controlling the PES power as necessary.

Solution to Problem

In order to solve the above problem, one representative power line management device of the present invention is a power line management system including a power line, a power line management device which manages a power line, and a communication network for information communication between the power line and the power line management device. The power line management device includes a processor and a memory. The memory includes a storage unit which stores power load prediction information indicating prediction of a power load in the power line and power generation prediction information indicating prediction of power generated by a power plant in the power line, an index calculation unit which calculates stability index information indicating a stability index for evaluating stability of the power line on the basis of the power load prediction information and the power generation prediction information, a power information acquisition unit which acquires power load information indicating an actual power load in the power line and power generation information indicating power actually generated by a power plant in the power line from the power line via the communication network, and a stability evaluation unit which calculates a stability score related to the power line on the basis of the power load information and the power generation information, and generates a stability evaluation result indicating the stability of the power line on the basis of the stability score and the stability index information.

Advantageous Effects of Invention

According to the present disclosure, it is possible to provide a power line management means capable of suppressing occurrence of an oscillation such as a SSO and securing stability of a power line by comparing, for each bus in the power line, a stability score, which is obtained on the basis of power related to a power electronics system (PES) leading to instability of the power line and total power related to the bus, with a predetermined stability index, evaluating stability of the power line, and controlling the PES power as necessary.

Problems, configurations, and effects other than those described above will be clarified by the following description of embodiments for carrying out the invention.

Brief Description of Drawings

[FIG. 1] FIG. 1 is a diagram illustrating a computer system for carrying out an embodiment of the present disclosure.
[FIG. 2] FIG. 2 is a diagram illustrating an example of a configuration of a power line management system according to the embodiment of the present disclosure.
[FIG. 3] FIG. 3 is a diagram illustrating an example of power load information according to the embodiment of the present disclosure.
[FIG. 4] FIG. 4 is a diagram illustrating an example of power generation information according to the embodiment of the present disclosure.
[FIG. 5] FIG. 5 is a diagram illustrating an example of a flow of power line stability evaluation processing according to the embodiment of the present disclosure.
[FIG. 6] FIG. 6 is a diagram illustrating an example of a logical configuration of a power line management system according to the embodiment of the present disclosure.
[FIG. 7] FIG. 7 is a diagram illustrating an example of stability index information according to the embodiment of the present disclosure.
[FIG. 8] FIG. 8 is a diagram illustrating an example of a flow of stability index information generation processing according to the embodiment of the present disclosure.
[FIG. 9] FIG. 9 is a diagram illustrating a voltage waveform indicating that a power line is stable, as a stability simulation result according to the embodiment of the present disclosure.
[FIG. 10] FIG. 10 is a diagram illustrating a voltage waveform indicating that the power line possibly becomes unstable, as the stability simulation result according to the embodiment of the present disclosure.
[FIG. 11] FIG. 11 is a diagram illustrating an example of a stability evaluation result screen according to the embodiment of the present disclosure.

Description of Embodiments

Hereinafter, an embodiment of the present invention will be described with reference to the drawings. Note that the present invention is not limited by this embodiment. In the drawings, the same portions are denoted by the same reference numerals.

In addition, it will be understood that although the terms such as "first", "second", and "third" may be used in the present disclosure to describe various elements or components, these elements or components should not be limited by these terms. These terms are only used to distinguish one element or component from another. Thus, a first element or component discussed below may also be referred to as a second element or component without departing from the teachings of the inventive concepts.

(Outline of present invention)

As described above, as demand for clean energy increases, introduction of renewable energy systems (RES) into power lines is expanding. Since the amount of power generated by RES varies due to various causes such as sunshine hours and wind direction, the supply to the power line easily becomes unstable. In order to control this unstable power supply, a so-called power electronics system (PES) is used. The PES is equipment for performing power conversion and control, and includes, for example, an inverter, a battery energy storage system (BESS), a static reactive power compensator (STATCOM), a series capacitor, a direct-current transmission line (HVDC), and the like.

However, in a certain region, when the density of the PES increases, a variation in grid impedance of the power line, an interaction between the PESs, or the like may cause an oscillation in voltage, power, frequency, or current referred to as a torsional oscillation (SSO: sub-synchronous oscillation). The SSO may cause damage to equipment such as a transmission line and a transformer in the power line, and may cause a power failure, so that it is desirable to suppress the SSO.

In this regard, in the present disclosure, for each bus in the power line, a ratio of power related to a PES and total power related to the bus (that is, PES power usage rate) is obtained as a stability score related to the power line. Then, by comparing the obtained stability score with a stability index that defines a boundary between a "stable state" and an "unstable state" in the power line, the current stability of the power line can be evaluated. By continuously or periodically performing this evaluation in real time, it is possible to determine that the power line possibly becomes unstable, before an oscillation such as the SSO occurs. Then, by transmitting a PES power generation amount suppression request for requesting suppression of the PES power to, for example, a power plant using RES in the power line, it is possible to control the usage rate of the PES power.

As described above, according to the power line management means according to the embodiment of the present disclosure, it is possible to suppress the occurrence of the oscillation such as the SSO and secure the stability of the power line.

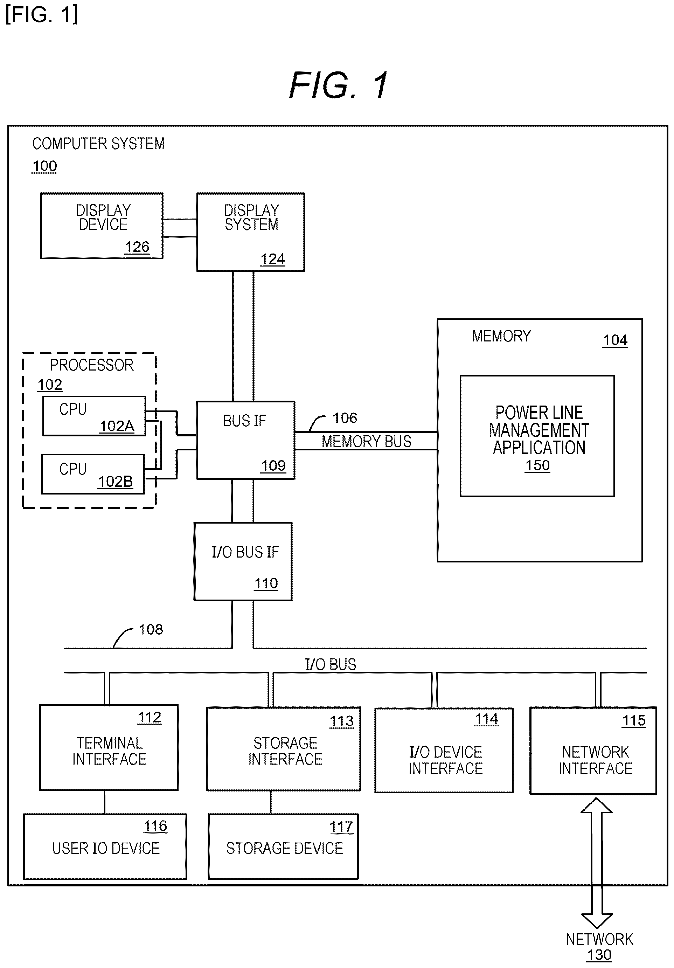

Next, a computer system 100 for implementing embodiments of the present disclosure will be described with reference to FIG. 1. The mechanisms and device of various embodiments disclosed herein may be applied to any suitable computing system. The main components of the computer system 100 include one or more processors 102, a memory 104, a terminal interface 112, a storage interface 113, an I/O (input/output) device interface 114, and a network interface 115. These components may be interconnected via a memory bus 106, an I/O bus 108, a bus interface unit 109, and an I/O bus interface unit 110.

The computer system 100 may include one or more general purpose programmable central processing units (CPU) 102A and 102B, collectively referred to as the processors 102. In an embodiment, the computer system 100 may comprise a plurality of processors, and in another embodiment, the computer system 100 may be a single CPU system. Each processor 102 executes instructions stored in the memory 104 and may include an on-board cache.

In an embodiment, the memory 104 may include a random access semiconductor memory, a storing device, or a storage medium (either volatile or non-volatile) for storing data and programs. The memory 104 may store all or part of programs, modules, and data structures for realizing the functions described herein. For example, the memory 104 may store a power line management application 150. In an embodiment, the power line management application 150 may include instructions or descriptions for performing the functions described later on the processor 102.

In an embodiment, the power line management application 150 may be realized in hardware via semiconductor devices, chips, logic gates, circuits, circuit cards, and/or other physical hardware devices instead of or in addition to a processor-based system. In an embodiment, the power line management application 150 may include data other than instructions or descriptions. In an embodiment, a camera, sensor, or other data input device (not illustrated) may be provided to communicate directly with the bus interface unit 109, the processor 102, or other hardware of the computer system 100.

The computer system 100 may include the bus interface unit 109 which performs communications among the processor 102, the memory 104, a display system 124, and the I/O bus interface unit 110. The I/O bus interface unit 110 may be coupled with the I/O bus 108 for transferring data to and from various I/O units. The I/O bus interface unit 110 may communicate with a plurality of I/O interface units 112, 113, 114 and 115, also known as I/O processors (IOP) or I/O adapters (IOA), via the I/O bus 108.

The display system 124 may include a display controller, a display memory, or both. The display controller may provide video, audio, or both data to a display device 126. In addition, the computer system 100 may also include devices, such as one or more sensors, configured to collect data and provide the data to the processor 102.

For example, the computer system 100 may include an environmental sensor which collects humidity data, temperature data, pressure data, and the like. Other types of sensors can also be used. The display system 124 may be connected to the display device 126 such as a single display screen, television, tablet, or portable device.

The I/O interface unit has a function of communicating with various storage or I/O devices. For example, the terminal interface unit 112 can be attached with a user I/O device 116 such as a user output device such as a video display device or a speaker television, or a user input device such as a keyboard, a mouse, a keypad, a touchpad, a trackball, a button, a light pen, or another pointing device. A user may input data and instructions to the user I/O device 116 and the computer system 100 and receive output data from the computer system 100 by using a user interface to operate a user input device. The user interface may be displayed on a display device, reproduced by a speaker, or printed via a printer, for example, via the user I/O device 116.

The storage interface 113 can be attached with one or more disk drives or direct access storage devices 117 (which is typically a magnetic disk drive storage device, but may be an array of disk drives or other storage devices configured to appear as a single disk drive). In an embodiment, the storage device 117 may be implemented as any secondary storing device. The contents of the memory 104 may be stored in the storage device 117 and read from the storage device 117 as necessary. The I/O device interface 114 may provide an interface to another I/O device, such as a printer and fax machine. The network interface 115 may provide a communication path so that the computer system 100 and another device can communicate with each other. This communication path may be, for example, a network 130.

In an embodiment, the computer system 100 may be a device which receives requests from another computer system (client), such as a multi-user mainframe computer system, a single-user system, or a server computer, which do not have a direct user interface. In another embodiment, the computer system 100 may be a desktop computer, a portable computer, a notebook computer, a tablet computer, a pocket computer, a phone, a smartphone, or any other suitable electronic device.

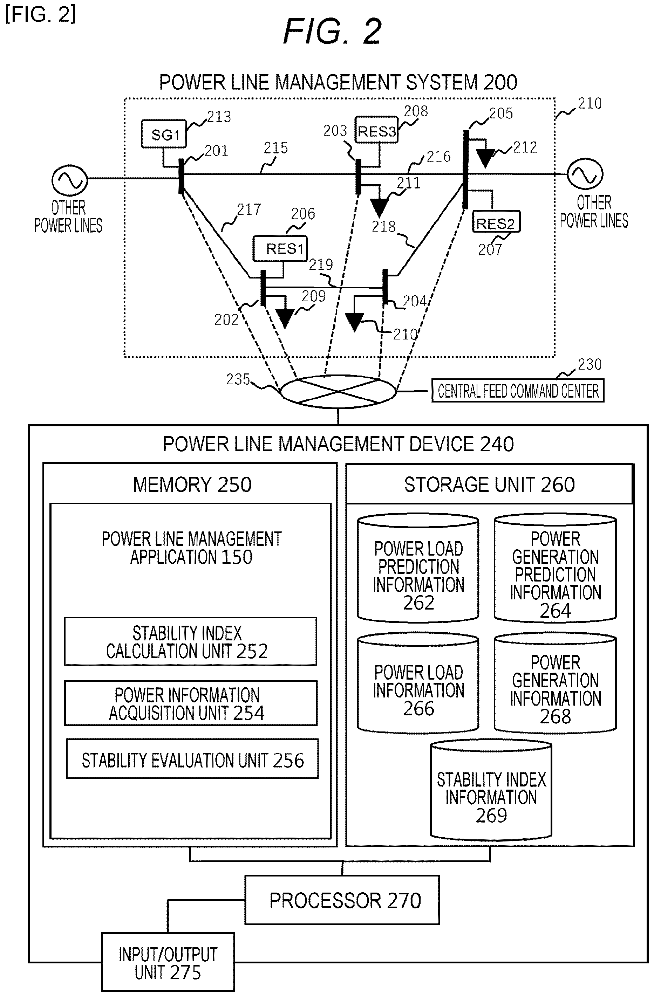

Next, a configuration of the power line management system according to the embodiment of the present disclosure will be described with reference to FIG. 2.

FIG. 2 is a diagram illustrating an example of a configuration of a power line management system 200 according to the embodiment of the present disclosure. The power line management system 200 is a system which secures the stability of the power line by evaluating the stability of the power line and controlling the power as necessary, and as illustrated in FIG. 2, includes a power line 220, a central feed command center 230, a communication network 235, and a power line management device 240. In the power line management system 200, the power line 220, the central feed command center 230, and the power line management device 240 are communicably connected via the communication network 235.

The power line 220 is a system which integrates power generation, power transformation, power transmission, and power distribution for supplying power generated by a power plant to power receiving equipment of a consumer. As illustrated in FIG. 2, the power line 220 includes a buses 201 to 205, renewable energy systems (RES) 206 to 208 which generate renewable energy, loads 209 to 212, a synchronous generator 213, and transmission lines 215 to 219. In addition, the power line 220 may be connected to another power line (not illustrated).

Note that the power line 220 illustrated in FIG. 2 is an example of the configuration of the power line according to the embodiment of the present disclosure, and the present disclosure is not limited to the configuration of the power line 220 illustrated in FIG. 2.

The bus 202, the bus 203, the bus 204, and the bus 205 mean collection points at which power equipment such as the generator, the load, and the power supply line of the power line 220 are connected. For example, the power generated by the RESs 206 to 208, the power supplied to the load 209, or the like flows through each of the bus 202, the bus 203, the bus 204, and the bus 205. The power flowing through the buses 201 to 205 includes, for example, the PES power generated by the RESs 206 to 208 using the PES or another PES, and the power generated by a non-PES that is not a PES. As will be described later, in the power line management means according to the embodiment of the present disclosure, for each bus in the power line, the PES power usage rate, which is a ratio of the PES power to the total power, is used to evaluate the stability of the power line.

The RESs 206, 207, and 208 are systems which generate renewable energy and supply the renewable energy to the power line 220, and include, for example, a power generator and a power plant which generate power by wind power generation or solar power generation. As described above, the amount of power generated by the RESs 206, 207, and 208 varies due to various causes such as sunlight hours and wind direction, so that a so-called power electronics system (PES) is used to control this unstable power supply. As illustrated in FIG. 2, the RES 206 is connected to the bus 202, the RES 207 is connected to the bus 205, and the RES 208 is connected to the bus 203.

Note that, here, the RESs 206, 207, and 208 using an inverter for controlling a power generation amount are illustrated as an example of equipment using the PES. However, the equipment using a PES is not limited to RES, and for example, equipment using another PES such as a battery energy storage system (BESS), a static reactive power compensator (STATCOM), a series capacitor, or a direct-current transmission line (HVDC) may also be included in the power line 220.

The loads 209, 210, 211, and 212 include equipment and devices which receive and consume, for example, power generated by the RESs 206 to 208 via the buses 201 to 205. As illustrated in FIG. 2, the load 209 is connected to the bus 202, the load 210 is connected to the bus 204, the load 211 is connected to the bus 203, and the load 212 is connected to the bus 205.

The synchronous generator 213 (in FIG. 2, denoted as "SG1") is a generator which generates power synchronized with a rotational speed at which a magnetic field generated by a field winding crosses an armature winding and supplies the power to the power line 220. Unlike the RESs 206 to 208, the synchronous generator 213 may be a non-PES which does not use a PES.

The central feed command center 230 is a facility which monitors the amount of power consumed by the loads 209 to 212 of the power line 220, and transmits, to the power generation system, a command to adjust the power generation amount of the power generation system such as the RESs 206 to 208 and the synchronous generator 213. In an embodiment, in a case where it is determined that the PES power usage rate is high and the power line 220 possibly becomes unstable, the central feed command center 230 may transmit the PES power generation amount suppression request from the power line management device 240 to the RESs 206 to 208 or the synchronous generator 213.

The communication network 235 is a network for information communication among the power line 220, the central feed command center 230, and the power line management device 240. The communication network 235 may include, for example, a wide area monitoring system (WAMS), a local area network (LAN), a wide area network (WAN), a satellite network, a cable network, a WiFi network, or any combination thereof. In an embodiment, the communication network 235 may be used to acquire power load information 266 and power generation information 268 described later from the power line 220.

The power line management device 240 is a device for securing the stability of the power line by evaluating the stability of the power line and controlling the power as necessary, and may be, for example, a computing device such as a server device. In an embodiment, the power line management device 240 may be implemented as the computer system 100 illustrated in FIG. 1.

As illustrated in FIG. 2, the power line management device 240 may include a memory 250, a storage unit 260, a processor 270, and an input/output unit 275.

The memory 250 may be a memory for storing the power line management application 150 for performing the function of the power line management means according to the embodiment of the present disclosure. As illustrated in FIG. 2, the power line management application 150 may include processing instructions for performing the functions of software modules such as a stability index calculation unit 252, a power information acquisition unit 254, and a stability evaluation unit 256.

The stability index calculation unit 252 is a functional unit for calculating stability index information indicating a stability index for evaluating the stability of the power line 220 on the basis of power load prediction information 262 and power generation prediction information 264 described later.

Note that details of the processing by the stability index calculation unit 252 will be described later, and thus description thereof will be omitted here.

The power information acquisition unit 254 is a functional unit for acquiring the power load information 266 and the power generation information 268 from the power line via the communication network 235.

Note that details of the processing by the power information acquisition unit 254 will be described later, and thus description thereof will be omitted here.

The stability evaluation unit 256 is a functional unit which calculates a stability score regarding the power line 220 on the basis of the power load information 266 acquired by the power information acquisition unit 254 and the power generation information 268, and generates a stability evaluation result indicating the stability of the power line 220 on the basis of the stability score and the stability index information calculated by the stability index calculation unit 252.

Note that details of the processing by the stability evaluation unit 256 will be described later, and thus description thereof will be omitted here.

The storage unit 260 is a storage area for storing various types of information according to the embodiment of the present disclosure, and may include the power load prediction information 262, the power generation prediction information 264, the power load information 266, the power generation information 268, and the stability index information as illustrated in FIG. 2.

The power load prediction information 262 is information indicating a predicted power load of the power line 220 for a predetermined period.

The power generation prediction information 264 is information indicating a power generation amount predicted to be supplied to the power line 220 for the predetermined period.

The power load prediction information 262 and the power generation prediction information 264 are generated in advance by, for example, an electric power company that manages a power line, and are stored in the storage unit 260 of the power line management device 240.

The power load information 266 is information indicating an actual power load in the power line 220 for the predetermined period.

The power generation information 268 is information indicating a power generation amount actually supplied to the power line 220 for the predetermined period.

The power load information 266 and the power generation information 268 are acquired by the power information acquisition unit 254 from the power line 220 via the communication network 235 and stored in the storage unit 260 of the power line management device 240.

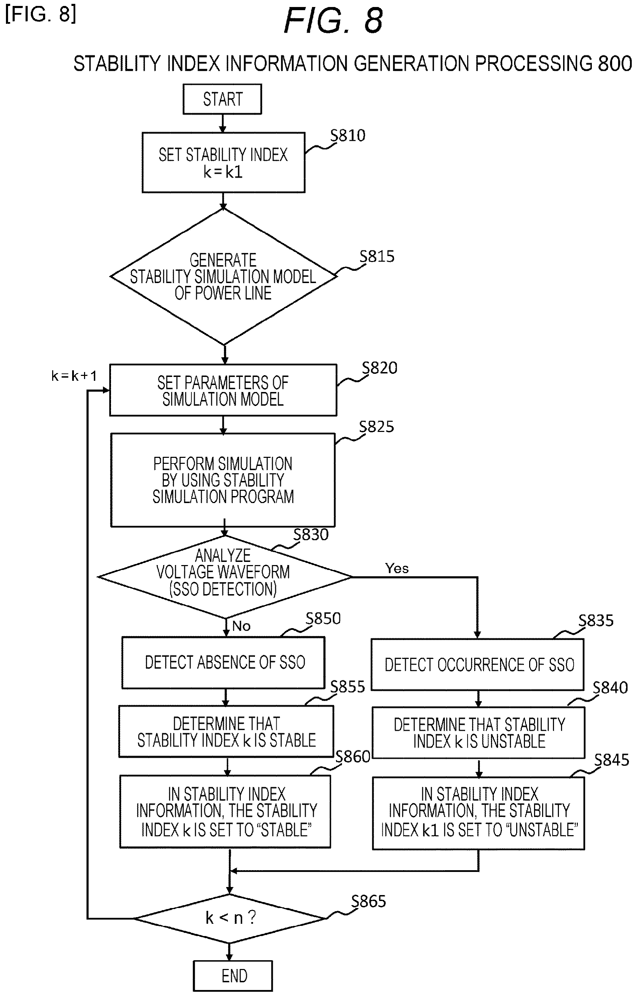

Stability index information 269 is information that defines a boundary between a "stable state" and an "unstable state" in the power line, and is used to evaluate the stability of the power line by comparison with the stability score calculated for the power line. The stability index information 269 is generated by stability index information generation processing 800 described later with reference to FIG. 8.

The processor 270 is a processing unit for executing a processing instruction that defines a function of each functional unit of the power line management application 150 stored in the memory 250.

The input/output unit 275 is a functional unit for receiving information input to the power line management device 240 and outputting information such as the stability evaluation result and the PES power generation amount suppression request generated by the power line management device 240. The input/output unit 275 may include, for example, a keyboard, a mouse, a display for displaying a graphical user interface (GUI), a communication function for transmitting and receiving information, and the like.

According to the power line management system 200 described above, it is possible to suppress the occurrence of the oscillation such as the SSO and secure the stability of the power line.

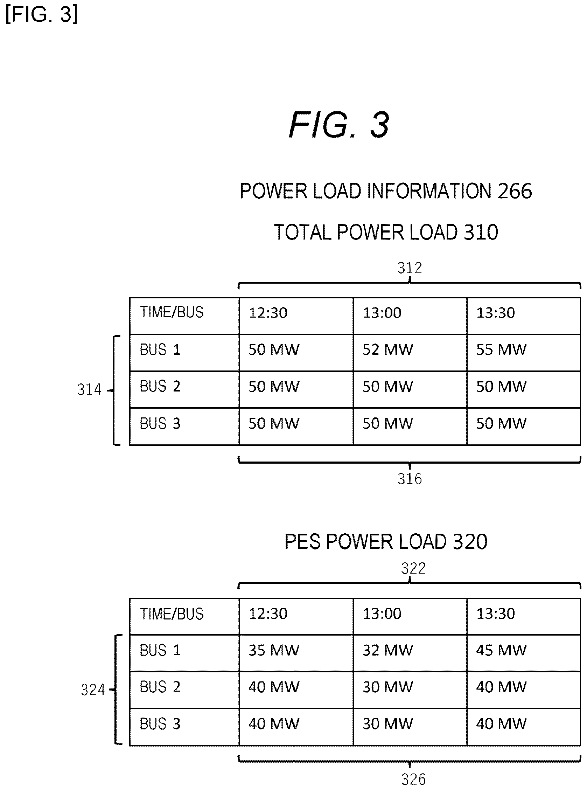

Next, the power load information according to the embodiment of the present disclosure will be described with reference to FIG. 3.

FIG. 3 is a diagram illustrating an example of the power load information 266 according to the embodiment of the present disclosure. As described above, the power load information 266 is the information indicating the actual power load in the power line 220 for the predetermined period, and is acquired by the power information acquisition unit 254 from the power line 220 via the communication network 235.

More specifically, for each bus in the power line 220, the power load information 266 includes a total power load 310 related to the PES and the non-PES and a PES power load 320 related to the PES for the predetermined period. Here, the expression "PES power load" means the power supplied from the power line to a power receiver by using the PES, and the expression "total power load" means the power supplied from the power line to the power receiver by using the PES and the non-PES.

As illustrated in FIG. 2, the total power load 310 may include time information 312, bus information 314, and a total power load value 316. As an example, the total power load 310 may indicate values (50 MW, 55 MW, and the like) of the total power load of each of the buses 1, 2, and 3 in the power line at intervals of 30 minutes of, for example, 12:30, 13:00, and 13:30.

As illustrated in FIG. 2, the PES power load 320 may also include time information 322, bus information 324, and a PES power load value 326. As an example, the PES power load 320 may indicate values (35 MW, 45 MW, and the like) of the PES power load of each of the buses 1, 2, and 3 in the power line at intervals of 30 minutes of, for example, 12:30, 13:00, and 13:30.

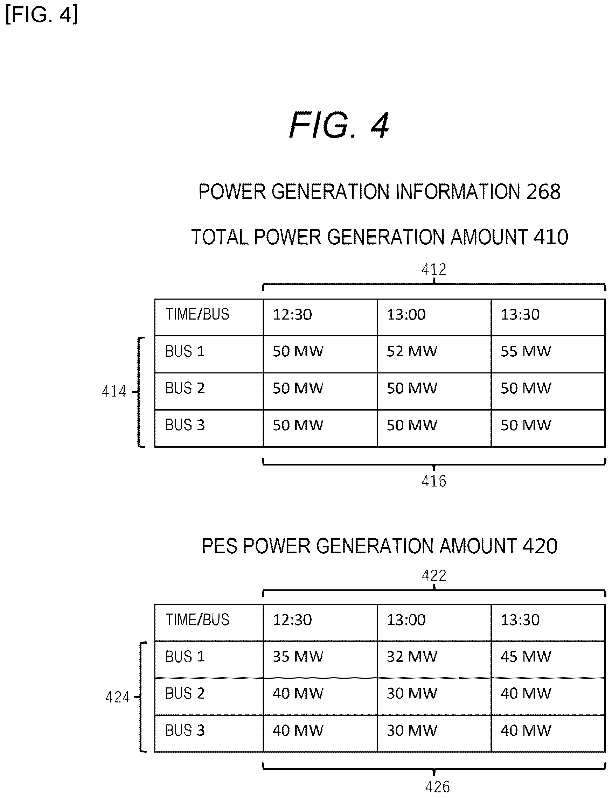

Next, the power generation information according to the embodiment of the present disclosure will be described with reference to FIG. 4.

FIG. 4 is a diagram illustrating an example of the power generation information 268 according to the embodiment of the present disclosure. As described above, the power generation information 268 is the information indicating the power generation amount actually supplied to the power line 220 for the predetermined period, and is acquired by the power information acquisition unit 254 from the power line 220 via the communication network 235.

More specifically, for each bus in the power line 220, the power generation information 268 includes a total power generation amount 410 related to the PES and the non-PES and a PES power generation amount 420 related to the PES for the predetermined period. Here, the expression "PES power generation amount" means the power supplied to the power line by using the PES, and the expression "total power generation amount" means the power supplied to the power line by using the PES and the non-PES.

As illustrated in FIG. 2, the total power generation amount 410 may include time information 412, bus information 414, and a total power generation amount value 416. As an example, the total power generation amount 410 may indicate values (50 MW, 55 MW, and the like) of the power generation amount of each of the buses 1, 2, and 3 in the power line at intervals of 30 minutes of, for example, 12:30, 13:00, and 13:30.

As illustrated in FIG. 2, the PES power generation amount 420 may include time information 422, bus information 424, and a PES power generation amount value 426. As an example, the PES power generation amount 420 may indicate value (35 MW, 45 MW, and the like) of the PES power generation amount of each of the buses 1, 2, and 3 in the power line at intervals of 30 minutes of, for example, 12:30, 13:00, and 13:30.

As described above, by using the power load information 266 and the power generation information 268 described with reference to FIGS. 3 and 4, the usage rate of the PES power for each bus in the power line can be calculated as the stability score of the power line. Then, by comparing the stability score calculated in this manner with a stability index that defines a boundary between the "stable state" and the "unstable state" in the power line, the current stability of the power line can be evaluated.

Note that the power load prediction information 262 and the power generation prediction information 264 described above are substantially similar to the power load information 266 and the power generation information 268 illustrated in FIGS. 3 and 4 except that they indicate a predicted power load and a power generation amount instead of the actual power load and the actual power generation amount, and thus illustration thereof is omitted.

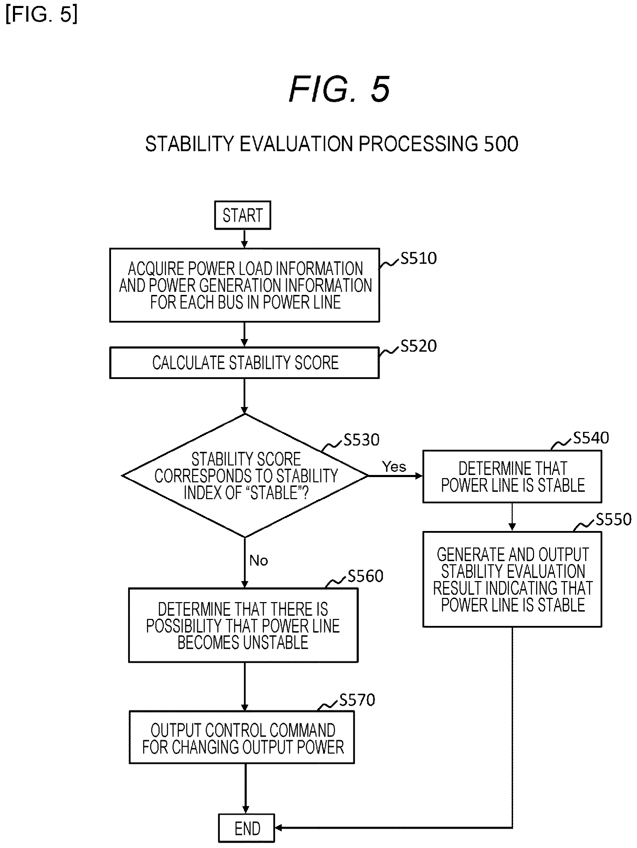

Next, power line stability evaluation processing according to the embodiment of the present disclosure will be described with reference to FIG. 5.

FIG. 5 is a diagram illustrating an example of a flow of power line stability evaluation processing 500 according to the embodiment of the present disclosure. The power line stability evaluation processing 500 illustrated in FIG. 5 is processing of determining whether the power line is stable or possibly becomes unstable, by using the stability score based on the usage rate of the PES power in each bus of the power line, and is executed by the power line management device 240 illustrated in FIG. 2.

First, in step S510, the power information acquisition unit 254 acquires the power load information 266 and the power generation information 268 for each bus (for example, the bus 202, the bus 203, the bus 204, and the bus 205 illustrated in FIG. 2) in the power line (for example, the power line 220 illustrated in FIG. 2). Here, for example, the power information acquisition unit 254 may transmit a request for transferring the power load information 266 and the power generation information 268 of the bus via the communication network 235, to each bus in the power line.

Next, in step S520, the stability evaluation unit 256 calculates the stability score regarding the power line on the basis of the power load information 266 and the power generation information 268 acquired in step S510. In an embodiment, for each bus in the power line, the stability evaluation unit 256 may calculate the usage rate of the PES power of the bus, and set, as the stability score, the average value of the usage rates of the PES power of the buses. Here, the "PES power" means power subjected to power feeding, power transmission, power reception, power distribution, transformation, control, or other adjustment by the PES in the power line. In addition, the expression of "PES power usage rate" means the ratio between the PES power related to each bus and the total power (that is, the sum of the PES power and the non-PES power related to the non-PES).

More specifically, for each bus in the power line, the stability evaluation unit 256 may calculate the PES power usage rate in the power line by dividing the sum of the PES power load (see the PES power load 320 illustrated in FIG. 3) included in the power load information 266 and the PES power generation amount (see the PES power generation amount 420 illustrated in FIG. 4) included in the power generation information 268 by the sum of the total power load (see the total power load 310 illustrated in FIG. 3) included in the power load information 266 and the total power generation amount (see the total power generation amount 410 illustrated in FIG. 4) included in the power generation information 268, and may set, as the stability score, the average value of the PES power usage rates of each bus.

The PES power usage rate is obtained by, for example, following Expression 1.

[Expression 1]

$$PES \ power \ usage = \left( \frac{P_{PES}(load) + P_{PES}(gen)}{P_{total}(load) + P_{total}(gen)} \right) \times 100$$

Here, $P_{PES}(load)$ is a PES power load of a specific bus, $P_{PES}(gen)$ is a PES power generation amount of the bus, $P_{total}(load)$ is a total power load of the bus, and $P_{total}(gen)$ is a total power generation amount of the bus.

Thereafter, the stability evaluation unit 256 may calculate the average value of the PES power usage rates calculated for each bus and use, as the stability score, the average value of the PES power usage rates. In an embodiment, for each bus, the stability evaluation unit 256 may set weights for each bus based on the importance of the bus or the like, calculate a weighted average value of the PES power usage rate on the basis of the weights and the PES power usage rate calculated for each bus, and use, as the stability score, the weighted average value of the power usage rate.

Next, in step S530, the stability evaluation unit 256 evaluates the stability of the power line by comparing the stability score calculated in step S520 with stability index information generated in advance, and determines whether the power line is stable or possibly becomes unstable.

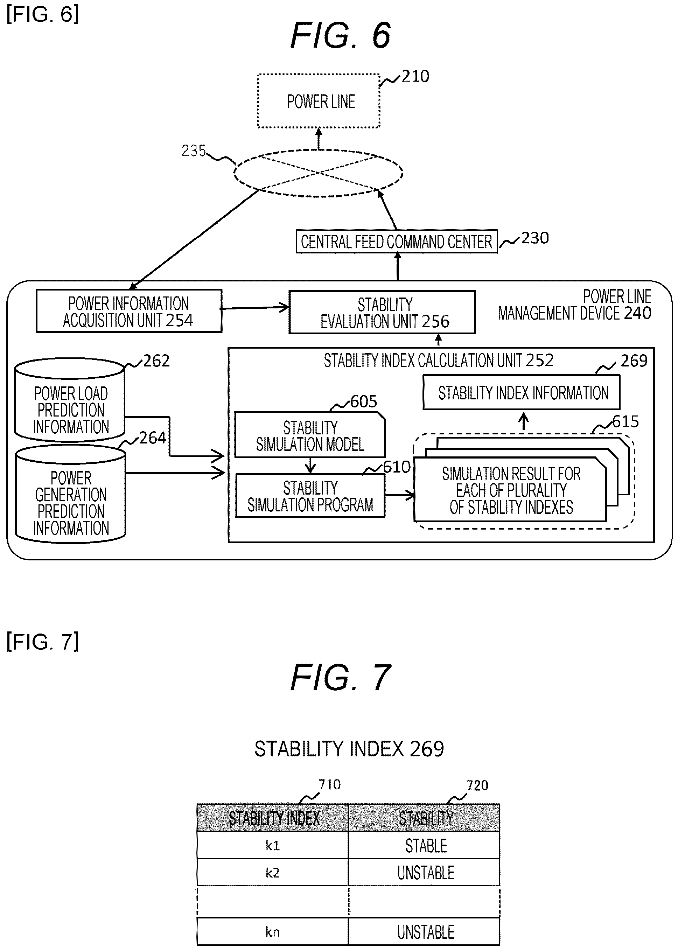

More specifically, as a result of comparing the stability score calculated in step S520 with the stability index information generated in advance (for example, the stability index information 269 illustrated in FIG. 7), in a case where the stability evaluation unit 256 determines that the stability score corresponds to the stability index of "unstable" in the stability index information, this processing proceeds to step S560.

On the other hand, as a result of comparing each stability score calculated in step S520 with the stability index information generated in advance (for example, the stability index information 269 illustrated in FIG. 7), in a case where the stability evaluation unit 256 determines that the stability score corresponds to the stability index of "stable" in the stability index information, this processing proceeds to step S540.

Note that the expression that the stability score "corresponds" to the stability index means that the stability score is within a tolerance range set for the specific stability index. This tolerance range may be arbitrarily set, for example, ±5%, 10%, or the like of the stability index.

Next, in step S540, the stability evaluation unit 256 determines that the power line is stable since the stability score corresponds to the stability index of "stable" in the stability index information, indicating that the PES power usage rate in the power line is appropriate and there is no possibility that the SSO occurs.

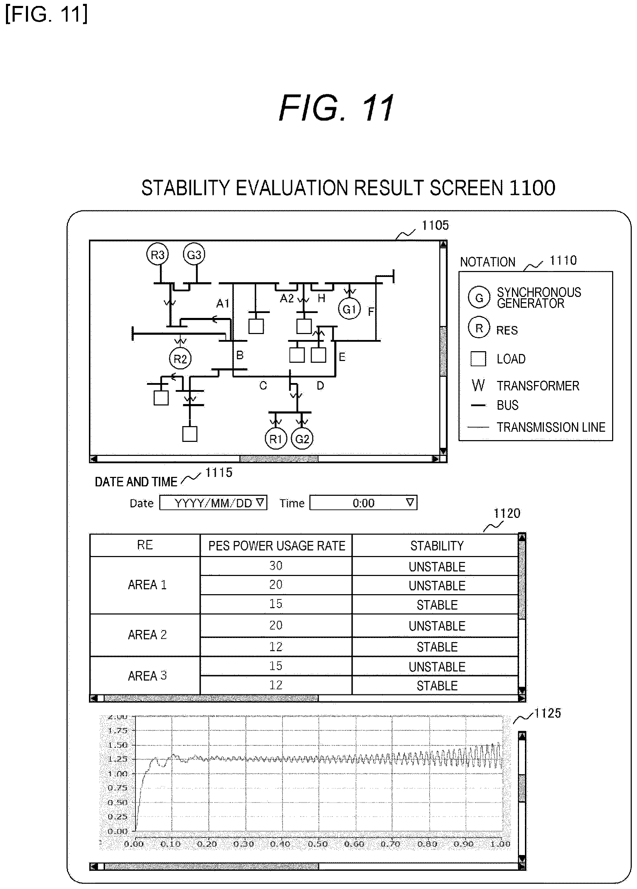

Next, in step S550, the stability evaluation unit 256 may generate a stability evaluation result indicating that the power line is stable, and output the stability evaluation result via a stability evaluation result screen 1100 described later with reference to FIG. 11, for example.

On the other hand, in step S560, the stability evaluation unit 256 determines that the power line possibly becomes unstable since the stability score corresponds to the stability index of "unstable" in the stability index information, indicating that the PES power usage rate in the power line is high and there is a possibility that the SSO occurs.

Next, in step S570, the stability evaluation unit 256 may generate a stability evaluation result indicating that the power line possibly becomes unstable, output the stability evaluation result via the stability evaluation result screen 1100 described later with reference to FIG. 11, for example, and transmit a request for suppressing the PES power usage rate to the power plant in the power line. As an example, the stability evaluation unit 256 may transmit the PES power generation amount suppression request for requesting suppression of the PES power generation amount to the power plant using RES in the power line, so as to transmit the request to the central feed command center.

According to the power line stability evaluation processing 500 described above, for example, the stability of the power line can be evaluated on the basis of the PES power usage rate of each bus in the power line.

Note that the power line stability evaluation processing 500 described above may be performed periodically or continuously. For example, by monitoring the power line in real time and continuously acquiring the power load information 266 and the power generation information 268, it is possible to evaluate the stability of the power line at any time.

Next, a logical configuration of the power line management system according to the embodiment of the present disclosure will be described with reference to FIG. 6.

FIG. 6 is a diagram illustrating an example of a logical configuration of the power line management system 200 according to the embodiment of the present disclosure. As described above, the power line management system 200 according to the embodiment of the present disclosure is a system which secures the stability of the power line by evaluating the stability of the power line and controlling the power as necessary, and as illustrated in FIG. 6, includes the power line 220, the central feed command center 230, the communication network 235, and the power line management device 240.

Before performing the power line stability evaluation processing 500 (see FIG. 5) on the power line 220, the power line management device 240 performs the stability index information generation processing 800 (see FIG. 8) of generating the stability index information 269 used in the power line stability evaluation processing 500.

More specifically, the stability index calculation unit 252 in the power line management device 240 inputs, for example, the power load prediction information 262 and the power generation prediction information 264 acquired in advance from an electric power company or the like. As described above, the power load prediction information 262 is information indicating a predicted power load of the power line 220 for the predetermined period, and the power generation prediction information 264 is information indicating a power generation amount predicted to be supplied to the power line 220 for the predetermined period.

Next, the stability index calculation unit 252 generates stability simulation model 605 on the basis of the power load prediction information 262 and the power generation prediction information 264. The stability simulation model 605 is information that defines the configuration and state of the power line 220. In an embodiment, the parameters of the load and the power generation amount in the stability simulation model 605 may be set on the basis of the power load prediction information 262 and the power generation prediction information 264.

Next, the stability index calculation unit 252 analyzes the stability simulation model 605 by using stability simulation program 610 to generate a simulation result 615 indicating the behavior of the power line 220 for each of a plurality of different stability indexes. In an embodiment, the stability simulation program 610 may be a simulation program that generates a voltage waveform predicted in the power line 220 for a specific PES power usage rate. In this case, the simulation result 615 may be information of a voltage waveform generated for each different PES power usage rate.

Next, the stability index calculation unit 252 analyzes the simulation result 615 generated by the stability simulation program 610 and determines whether each simulation result indicates a stable behavior (for example, a stable voltage waveform) or an unstable behavior (for example, a voltage waveform in which an oscillation is present), thereby generating the stability index information 269 by using the PES power usage rate corresponding to each simulation result 615 as the stability index that defines the boundary between the "stable state" and the "unstable state" in the power line 220.

Note that details of the stability index information generation processing 800 of generating the stability index information 269 will be described later with reference to FIG. 8, and thus description thereof will be omitted here.

After the stability index information 269 is generated, the stability evaluation unit 256 compares the stability score, which is calculated on the basis of the power load information 266 and the power generation information 268 acquired by the power information acquisition unit 254 from the power line 220 via the communication network 235, with the stability index information 269, thereby evaluating the stability of the power line 220. In a case where it is determined that the power line 220 possibly becomes unstable, for example, the power line management device 240 may transmit the PES power generation amount suppression request for requesting suppression of the PES power generation amount to the power plant in the power line 220 via the central feed command center 230, the communication network 235, or the like.

Note that the details of the power line stability evaluation processing 500 for evaluating the stability of the power line 220 have been described with reference to FIG. 5, and thus the description thereof will be omitted here.

Next, the stability index information according to the embodiment of the present disclosure will be described with reference to FIG. 7.

FIG. 7 is a diagram illustrating an example of the stability index information 269 according to the embodiment of the present disclosure. As described above, the stability index information 269 according to the embodiment of the present disclosure is information that defines the boundary between the "stable state" and the "unstable state" in the power line, and is used to evaluate the stability of the power line by comparison with the stability score calculated for the power line.

Note that the stability index information 269 illustrated in FIG. 7 may be generated in the stability index information generation processing described later with reference to FIG. 8 and stored in the storage unit 260.

As illustrated in FIG. 7, the stability index information 269 may include information of stability index 710 and stability 720.

The stability index 710 is information indicating a value of a usage rate of predetermined PES power. For example, the stability index 710 may be, for example, "10%", "30%", "50%", or the like.

The stability 720 is information indicating whether the power line is stable or unstable with a specific stability index for each stability index 710. For example, the stability 720 may indicate that a predetermined stability index "K1" (for example, PES power usage rate of 10%) is "stable" and a stability index "K2" (for example, PES power usage rate of 60%) is "unstable".

As described above, after the stability score is calculated for the power line, the stability score is compared with the stability index information 269 illustrated in FIG. 7, whereby whether the stable score corresponds to the stability index of "stable" or the stability index of "unstable" can be determined. Thereafter, by controlling the usage rate of the PES power in the power line on the basis of this determination, the stability of the power line can be secured.

Note that the expression that the stability score "corresponds" to the stability index means that the stability score is within a tolerance range set for the specific stability index. This tolerance range may be arbitrarily set, for example, ±5%, 10%, or the like of the stability index. For example, in a case where the stability index is "50%", the stability score is "52%", and the tolerance range is "± 10% of the stability index", it can be determined that the stability score of "52%" corresponds to the stability index of "50%".

Next, the stability index information generation processing according to the embodiment of the present disclosure will be described with reference to FIG. 8.

FIG. 8 is a diagram illustrating an example of a flow of the stability index information generation processing 800 according to the embodiment of the present disclosure. The stability index information generation processing 800 is processing of defining the boundary between the "stable state" and the "unstable state" in the power line and generating the stability index information to be used to evaluate the stability of the power line, and is performed by the stability index calculation unit 252 in the power line management device 240 illustrated in FIG. 2.

First, in step S810, the stability index calculation unit 252 sets a stability index "k" to a predetermined initial value "k1". As described above, the stability index may be a value of a predetermined PES power usage rate. Here, the initial value k1 of the stability index may be set to an arbitrary value.

Next, in step S815, the stability index calculation unit 252 generates a stability simulation model of the power line. This stability simulation model is information that defines the configuration and state of the power line 220. In an embodiment, the stability index calculation unit 252 may use, as the stability simulation model, an existing simulation model for simulating a voltage in the power line.

Next, in step S820, the stability index calculation unit 252 sets model parameters in the stability simulation model generated in step S815. More specifically, the stability index calculation unit 252 may set the parameters of the load, the power generation amount, and the PES power usage rate in the stability simulation model on the basis of the power load prediction information 262 and the power generation prediction information 264. As a result, a realistic simulation result can be obtained.

In an embodiment, the stability index calculation unit 252 may set a target range of the stability index analyzed in the simulation on the basis of the power load prediction information 262 and the power generation prediction information 264. For example, using Expression 1 described above, the stability index calculation unit 252 may set the minimum value (that is, the lower limit of the stability index) of the PES power usage rate in the simulation, to the PES usage rate obtained on the basis of the minimum values of the load and the power generation amount in the power load prediction information 262 and the power generation prediction information 264, and set the maximum value (that is, an upper limit kn of the stability index) of the PES power usage rate in the simulation, to the PES usage rate obtained on the basis of the maximum load and power generation amount in the power load prediction information 262 and the power generation prediction information 264.

Next, in step S825, the stability index calculation unit 252 analyzes the stability simulation model generated in step S815 by using the stability simulation program, thereby generating a simulation result indicating a predicted behavior of the power line for the stability index (for example, k1) indicating a specific PES power usage rate. In an embodiment, the stability simulation program may be a simulation program that generates a voltage waveform predicted in the power line for the specific PES power usage rate. In this case, the simulation result may be information of the voltage waveform generated for the stability index representing the specific PES power usage rate.

Next, in step S830, the stability index calculation unit 252 analyzes the voltage waveform indicated in the simulation result generated in step S825. Here, the stability index calculation unit 252 may determine whether or not a variation per unit time in the voltage waveform indicated by the simulation result is equal to or greater than a predetermined variation threshold. In a case where it is determined that there is a variation equal to or greater than the predetermined variation threshold in the voltage waveform, this processing proceeds to step S835. On the other hand, in a case where it is determined that there is no variation equal to or greater than the predetermined variation threshold in the voltage waveform, this processing proceeds to step S850.

Next, in a case where it is determined in step S830 that there is a variation equal to or greater than the predetermined variation threshold in the voltage waveform, in step S835, the stability index calculation unit 252 determines, for the stability index k1 indicating the PES power usage rate, that there is a possibility that the sub-synchronous oscillation (SSO) occurs in the power line.

Next, in step S840, the stability index calculation unit 252 determines, for the stability index k1 indicating the PES power usage rate, that there is a possibility that the SSO occurs in the power line, and thus the stability index k1 indicates the "unstable" state.

Next, in step S845, the stability index calculation unit 252 sets the stability index k1 to "unstable" in the stability index information 269 described above. More specifically, the stability index calculation unit 252 may associate a label "unstable" with the stability index k1 in the stability index information 269.

Thereafter, this processing proceeds to step S865.

On the other hand, in a case where it is determined in step S830 that there is a variation equal to or greater than the predetermined variation threshold in the voltage waveform, in step S850, the stability index calculation unit 252 determines, for the stability index k1 indicating the PES power usage rate, that there is no possibility that the sub-synchronous oscillation (SSO) occurs in the power line.

Next, in step S855, the stability index calculation unit 252 determines, for the stability index k1 indicating the PES power usage rate, that there is no possibility that the SSO occurs in the power line, and thus the stability index k1 indicates the "stable" state.

Next, in step S860, the stability index calculation unit 252 sets the stability index k1 to "stable" in the stability index information 269 described above. More specifically, the stability index calculation unit 252 may associate a label "stable" with the stability index k1 in the stability index information 269.

Thereafter, this processing proceeds to step S865.

Next, in step S865, the stability index calculation unit 252 determines whether or not the stability index k is equal to or less than the upper limit kn of the stability index. In a case where the stability index k is equal to or less than the upper limit kn of the stability index, this processing returns to step S820, and the stability index calculation unit 252 adds the stability index k. On the other hand, in a case where the qualitative index k is equal to or greater than the upper limit kn of the stability index, the stability index calculation unit 252 determines that the analysis of all the stability indexes in the target range of the stability index has been completed, and this processing ends.

According to the stability index information generation processing 800 described above, it is possible to generate the stability index information indicating the PES power usage rate that defines the boundary between the "stable state" and the "unstable state" in the power line. In this way, by preparing and storing the stability index information in advance, it is possible to evaluate the stability of the power line at any time.

Note that the stability index information generation processing 800 may be performed periodically (once a day, once a week), for example, or may be performed when the configuration of the power line or expected load and power generation amount changes.

As described above, in the stability index information generation processing 800 according to the embodiment of the present disclosure, the stability simulation for predicting the behavior of the power line is performed for each of a plurality of different PES power usage rates. In an embodiment, a voltage waveform corresponding to a specific PES power usage rate is used as the stability simulation result.

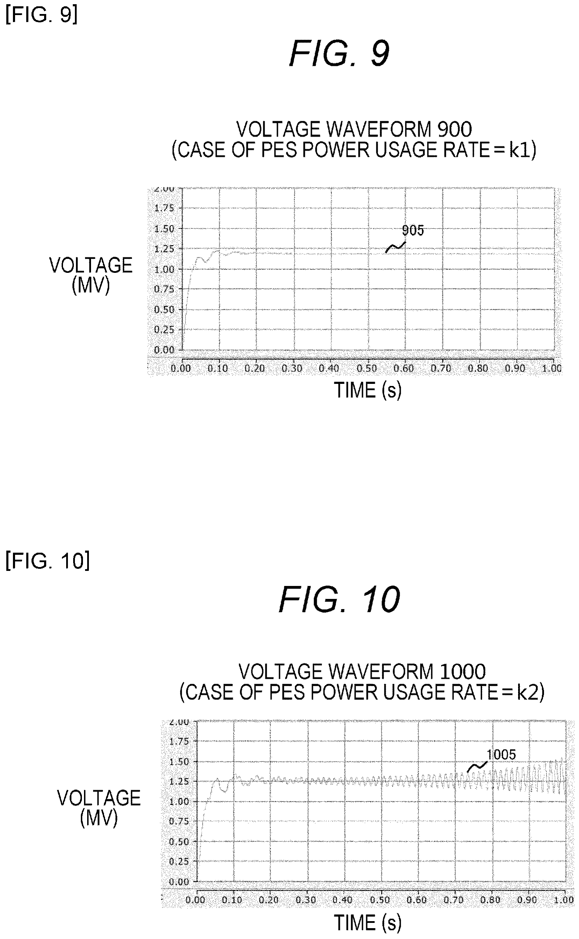

Next, a stability simulation result according to the embodiment of the present disclosure will be described with reference to FIGS. 9 and 10.

FIG. 9 is a diagram illustrating a voltage waveform 900 indicating that the power line is stable, as the stability simulation result according to the embodiment of the present disclosure. The voltage waveform 900 may be generated on the basis of, for example, a predetermined PES power usage rate k1. As illustrated in FIG. 9, a horizontal axis of the voltage waveform 900 represents time, and a vertical axis represents voltage.

As illustrated in FIG. 9, a transition 905 of the voltage per unit time remains flat, with no significant variation. Thus, since the variation in the transition 905 of the voltage per unit time is less than the predetermined variation threshold such as "0.25 MV/s", the stability index calculation unit 252 stores, as the stability index of "stable", the PES power usage rate k1 corresponding to the voltage waveform 900 in the stability index information 269.

FIG. 10 is a diagram illustrating a voltage waveform 1000 indicating that the power line possibly becomes unstable, as the stability simulation result according to the embodiment of the present disclosure. The voltage waveform 1000 may be generated on the basis of, for example, a predetermined PES power usage rate k2. As illustrated in FIG. 10, a horizontal axis of the voltage waveform 1000 represents time, and a vertical axis represents voltage.

As illustrated in FIG. 10, an oscillation (for example, SSO) occurs in a transition 1005 of the voltage per unit time. Thus, since the variation in the transition 1005 of the voltage per unit time is equal to or greater than the predetermined variation threshold such as "0.25 MV/s", for example, the stability index calculation unit 252 stores, as the stability index of "unstable", the PES power usage rate k2 corresponding to the voltage waveform 1000 in the stability index information 269.

Next, the stability evaluation result screen according to the embodiment of the present disclosure will be described with reference to FIG. 11.

FIG. 11 is a diagram illustrating an example of the stability evaluation result screen 1100 according to the embodiment of the present disclosure. The stability evaluation result screen 1100 illustrated in FIG. 11 is a screen showing the stability evaluation result generated by performing stability evaluation on the power line. The stability evaluation result screen 1100 may be displayed on, for example, a terminal of an electric power company that manages the power line, a terminal of a central feed command center, or the like.

As illustrated in FIG. 11, the stability evaluation result screen 1100 may include a power line diagram 1105, notation information 1110, date and time information 1115, a stability evaluation result 1120, and an SSO waveform diagram 1125.

The power line diagram 1105 is a diagram illustrating a configuration of the power line to be subjected to stability evaluation.

The notation information 1110 indicates notation used to indicate equipment such as a generator, RES, a load, a transformer, a bus, and a transmission line in the power line diagram 1105.

The date and time information 1115 is information indicating the date and time corresponding to the stability evaluation result.

The stability evaluation result 1120 is information generated by the power line stability evaluation processing 500 according to the embodiment of the present disclosure and indicating the stability of the power line. As illustrated in FIG. 11, the stability evaluation result 1120 may include, for each of a plurality of areas (area 1, area 2, area 3) included in the power line, a PES power usage rate calculated for a bus in the area and stability (stable or unstable) of the area.

The information of the stability evaluation result 1120 may be generated by the power line stability evaluation processing 500 described above.

The SSO waveform diagram 1125 is a graph showing a waveform diagram of the SSO that is predicted to occur in the "unstable" area in the stability evaluation result 1120. This SSO waveform diagram 1125 may be generated, for example, by the simulation described above. By selecting a specific area or bus in the stability evaluation result 1120, the user of the stability evaluation result screen 1100 can confirm the waveform diagram of the SSO that is predicted to occur in the area or bus.

As described above, in the power line management means according to the embodiment of the present disclosure, for each bus in the power line, the ratio of the power related to the PES and the total power related to the bus (that is, PES power usage rate) is obtained as the stability score related to the power line. Then, by comparing the obtained stability score with a stability index that defines a boundary between a "stable state" and an "unstable state" in the power line, the current stability of the power line can be evaluated.

In this way, by evaluating the stability of the power line on the basis of the PES power usage rate, for example, it is possible to quantitatively evaluate the instability of the power line due to a variation in grid impedance caused by an increase in the PES density accompanying the expansion of the introduction of RES and an interaction between PESs.

In addition, by continuously or periodically performing the stability evaluation of the power line in real time, it is possible to determine that the power line possibly becomes unstable, before an oscillation such as the SSO occurs. Then, by transmitting a PES power generation amount suppression request for requesting suppression of the PES power to, for example, a power plant using RES in the power line, it is possible to control the usage rate of the PES power and to prevent the occurrence of the SSO. As a result, it is possible to avoid damage caused by the SSO to equipment such as a transmission line and a transformer in the power line.

Although the embodiment of the present invention has been described above, the present invention is not limited to the above-described embodiment, and various modifications can be made without departing from the gist of the present invention.

As described above, the power line management means according to the embodiment of the present disclosure includes the following aspects.

(Aspect 1)

A power line management system which includes

a power line,
a power line management device which manages a power line,
a communication network for information communication between the power line and the power line management device, wherein
the power line management device includes:

a processor;
a memory; and
a storage unit which stores power load prediction information indicating prediction of a power load in the power line and power generation prediction information indicating prediction of power generated by a power plant in the power line, and
the memory includes a processing instruction for causing the processor to function as
a stability index calculation unit which calculates stability index information indicating a stability index for evaluating stability of the power line on the basis of the power load prediction information and the power generation prediction information,
a power information acquisition unit which acquires power load information indicating an actual power load in the power line and power generation information indicating power actually generated by a power plant in the power line from the power line via the communication network, and
a stability evaluation unit which calculates a stability score related to the power line on the basis of the power load information and the power generation information, and generates a stability evaluation result indicating the stability of the power line on the basis of the stability score and the stability index information.

(Aspect 2)

The power line management system according to aspect 1, in which

the power line includes
a plurality of buses to which a power electronics system (PES) and a non-PES are connected,
the power load information includes
a PES power load related to the PES and a total power load related to the PES and the non-PES for each of the buses in the power line, and
the power generation information includes
a PES power generation amount related to the PES and a total power generation amount related to the PES and the non-PES for each of the buses in the power line.

(Aspect 3)

The power line management system according to aspect 2, in which

the stability evaluation unit
calculates a PES power usage rate in the power line on the basis of the power load information and the power generation information by dividing a sum of the PES power load and the PES power generation amount of each bus in the power line by a sum of the total power load and the total power generation amount of each bus in the power line, and sets the PES power usage rate as the stability score.

(Aspect 4)

The power line management system according to any one of aspects 1 to 3, in which

the stability index calculation unit
determines a target range of a stability index on the basis of the power load prediction information and the power generation prediction information,
generates, for each stability index in the target range, a simulation result indicating a voltage predicted over time for a predetermined bus in the power line,

designates, for a first stability index in the target range, the first stability index as stable in a case where a variation of the voltage per unit time in the simulation result is less than a predetermined variation threshold, and

designates, for a second stability index in the target range, the second stability index as unstable in a case where a variation of the voltage per unit time in the simulation result is equal to or greater than the predetermined variation threshold, to generate the stability index information indicating whether each stability index in the target range is stable or unstable.

(Aspect 5)

The power line management system according to aspect 4, in which

the stability evaluation unit
generates a stability evaluation result indicating that the power line is stable, in a case where, as a result of comparing the stability score with the stability index information, it is determined that the stability score corresponds to the first stability index, and
generates a stability evaluation result indicating that the power line possibly becomes unstable, in a case where, as a result of comparing the stability score with the stability index information, it is determined that the stability score corresponds to the second stability index.

(Aspect 6)

The power line management system according to any one of aspects 1 to 5, in which

the power line management device
in a case where it is determined that the power line possibly becomes unstable, transmits, to a power plant in the power line, a PES power generation amount suppression request for requesting suppression of a PES power generation amount.

Reference Signs List

150 power line management application
200 power line management system
201, 202, 203, 204, 205 bus
206, 207, 208 RES
209, 210, 211, 212 load
213 synchronous generator
215, 216, 217, 218, 219 transmission line
220 power line
230 central feed command center
235 communication network
240 power line management device
250 memory
252 stability index calculation unit
254 power information acquisition unit
256 stability evaluation unit
260 storage unit
262 power load prediction information
264 power generation prediction information
266 power load information
268 power generation information
269 stability index information
270 processor
275 input/output unit

**Claims**

1. A power line management system comprising:

a power line;
a power line management device which manages a power line; and
a communication network for information communication between the power line and the power line management device, wherein
the power line management device includes:

a processor;
a memory; and
a storage unit which stores power load prediction information indicating prediction of a power load in the power line and power generation prediction information indicating prediction of power generated by a power plant in the power line, and
the memory includes a processing instruction for causing the processor to function as
a stability index calculation unit which calculates stability index information indicating a stability index for evaluating stability of the power line on a basis of the power load prediction information and the power generation prediction information,
a power information acquisition unit which acquires power load information indicating an actual power load in the power line and power generation information indicating power actually generated by a power plant in the power line from the power line via the communication network, and
a stability evaluation unit which calculates a stability score related to the power line on a basis of the power load information and the power generation information, and generates a stability evaluation result indicating the stability of the power line on a basis of the stability score and the stability index information.

2. The power line management system according to claim 1, wherein

the power line includes
a plurality of buses to which a power electronics system (PES) and a non-PES are connected,
the power load information includes
a PES power load related to the PES and a total power load related to the PES and the non-PES for each of the buses in the power line, and
the power generation information includes
a PES power generation amount related to the PES and a total power generation amount related to the PES and the non-PES for each of the buses in the power line.

3. The power line management system according to claim 2, wherein

the stability evaluation unit
calculates a PES power usage rate in the power line on a basis of the power load information and the power generation information by dividing a sum of the PES power load and the PES power generation amount of each bus in the power line by a sum of the total power load and the total power generation amount of each bus in the power line, and sets the PES power usage rate as the stability score.

4. The power line management system according to claim 1, wherein

the stability index calculation unit
determines a target range of a stability index on a basis of the power load prediction information and the power generation prediction information,
generates, for each stability index in the target range, a simulation result indicating a voltage predicted over time for a predetermined bus in the power line,
designates, for a first stability index in the target range, the first stability index as stable in a case where a variation of the voltage per unit time in the simulation result is less than a predetermined variation threshold, and
designates, for a second stability index in the target range, the second stability index as unstable in a case where a variation of the voltage per unit time in the simulation result is equal to or greater than the predetermined variation threshold, to generate the stability index information indicating whether each stability index in the target range is stable or unstable.

5. The power line management system according to claim 4, wherein

the stability evaluation unit
generates a stability evaluation result indicating that the power line is stable, in a case where, as a result of comparing the stability score with the stability index information, it is determined that the stability score corresponds to the first stability index, and
generates a stability evaluation result indicating that the power line possibly becomes unstable, in a case where, as a result of comparing the stability score with the stability index information, it is determined that the stability score corresponds to the second stability index.

6. The power line management system according to claim 1, wherein

the power line management device
in a case where it is determined that the power line possibly becomes unstable, transmits, to a power plant in the power line, a PES power generation amount suppression request for requesting suppression of a PES power generation amount.

7. A power line management method, wherein
in a computer system including a memory storing a processing instruction and a processor, the processing instruction stored in the memory causes the processor to execute:

a step of acquiring power load prediction information indicating prediction of a power load in a power line and power generation prediction information indicating prediction of power generated by a power plant in the power line;
a step of determining a target range of a stability index for evaluating stability of the power line on a basis of the power load prediction information and the power generation prediction information;
a step of generating, for each stability index in the target range, a simulation result indicating a voltage predicted over time for a predetermined bus in the power line,
a step of designating, for a first stability index in the target range, the first stability index as stable in a case where a variation of the voltage per unit time in the simulation result is less than a predetermined variation threshold;
a step of designating, for a second stability index in the target range, the second stability index as unstable in a case where a variation of the voltage per unit time in the simulation result is equal to or greater than the predetermined variation threshold, to generate stability index information indicating whether each stability index in the target range is stable or unstable;
a step of acquiring, from the power line, power load information including a PES power load related to a power electronics system (PES) and a total power load related to the PES and a non-PES for each bus in the power line, and power generation information including a PES power generation amount related to the PES and a total power generation amount related to the PES and the non-PES for each bus in the power line;
a step of calculating a PES power usage rate as a stability score regarding the power line on a basis of the power load information and the power generation information by dividing a sum of the PES power load and the PES power generation amount of each bus in the power line by a sum of the total power load and the total power generation amount of each bus in the power line;
a step of generating a stability evaluation result indicating that the power line is stable, in a case where, as a result of comparing the stability score with the stability index information, it is determined that the stability score corresponds to the first stability index;
a step of generating a stability evaluation result indicating that the power line possibly becomes unstable, in a case where, as a result of comparing the stability score with the stability index information, it is determined that the stability score corresponds to the second stability index; and
a step of transmitting, to a power plant in the power line, a PES power generation amount suppression request for requesting suppression of a PES power generation amount, in a case where it is determined that the power line possibly becomes unstable.

[FIG. 1]

# FIG. 1

COMPUTER SYSTEM
100

DISPLAY DEVICE 126

DISPLAY SYSTEM 124

PROCESSOR
102

CPU 102A

CPU 102B

BUS IF 109

106
MEMORY BUS

MEMORY 104

POWER LINE MANAGEMENT APPLICATION 150

I/O BUS IF 110

108

I/O BUS

112
TERMINAL INTERFACE

113
STORAGE INTERFACE

114
I/O DEVICE INTERFACE

115
NETWORK INTERFACE

116
USER IO DEVICE

117
STORAGE DEVICE

NETWORK 130

[FIG. 2]

# FIG. 2

## POWER LINE MANAGEMENT SYSTEM 200

## POWER LINE MANAGEMENT DEVICE 240

### MEMORY 250

**POWER LINE MANAGEMENT APPLICATION 150**

STABILITY INDEX CALCULATION UNIT 252

POWER INFORMATION ACQUISITION UNIT 254

STABILITY EVALUATION UNIT 256

### STORAGE UNIT 260

POWER LOAD PREDICTION INFORMATION 262

POWER GENERATION PREDICTION INFORMATION 264

POWER LOAD INFORMATION 266

POWER GENERATION INFORMATION 268

STABILITY INDEX INFORMATION 269

PROCESSOR 270

INPUT/OUTPUT UNIT 275

[FIG. 3]

# FIG. 3

## POWER LOAD INFORMATION 266

### TOTAL POWER LOAD 310

312

| TIME/BUS | 12:30 | 13:00 | 13:30 |
|----------|-------|-------|-------|
| BUS 1 | 50 MW | 52 MW | 55 MW |
| BUS 2 | 50 MW | 50 MW | 50 MW |
| BUS 3 | 50 MW | 50 MW | 50 MW |

316

### PES POWER LOAD 320

322

| TIME/BUS | 12:30 | 13:00 | 13:30 |
|----------|-------|-------|-------|
| BUS 1 | 35 MW | 32 MW | 45 MW |
| BUS 2 | 40 MW | 30 MW | 40 MW |
| BUS 3 | 40 MW | 30 MW | 40 MW |

326

[FIG. 4]

# FIG. 4

## POWER GENERATION INFORMATION 268

### TOTAL POWER GENERATION AMOUNT 410

412

| TIME/BUS | 12:30 | 13:00 | 13:30 |
|----------|-------|-------|-------|
| BUS 1 | 50 MW | 52 MW | 55 MW |
| BUS 2 | 50 MW | 50 MW | 50 MW |
| BUS 3 | 50 MW | 50 MW | 50 MW |

414

416

### PES POWER GENERATION AMOUNT 420

422

| TIME/BUS | 12:30 | 13:00 | 13:30 |
|----------|-------|-------|-------|
| BUS 1 | 35 MW | 32 MW | 45 MW |
| BUS 2 | 40 MW | 30 MW | 40 MW |
| BUS 3 | 40 MW | 30 MW | 40 MW |

424

426

[FIG. 5]

# FIG. 5

## STABILITY EVALUATION PROCESSING 500

```
                    ┌─────────┐
                    │  START  │
                    └─────────┘
                         │
                         ▼
    ┌───────────────────────────────────────┐
    │   ACQUIRE POWER LOAD INFORMATION       │ ⟋S510
    │ AND POWER GENERATION INFORMATION       │
    │     FOR EACH BUS IN POWER LINE         │
    └───────────────────────────────────────┘
                         │
                         ▼
    ┌───────────────────────────────────────┐
    │       CALCULATE STABILITY SCORE        │ ⟋S520
    └───────────────────────────────────────┘
                         │
                         ▼
              ◇─────────────────◇                              ⟋S540
             ╱   STABILITY SCORE   ╲      Yes      ┌──────────────────────┐
            ╱  CORRESPONDS TO STABILITY ╲─────────▶│    DETERMINE THAT    │
            ╲    INDEX OF "STABLE"?    ╱           │  POWER LINE IS STABLE │
             ╲─────────────────────╱              └──────────────────────┘
               ◇      ⟋S530                                    │
                    │                                          ▼
                    │ No                           ┌──────────────────────┐  ⟋S550
                    ▼                               │  GENERATE AND OUTPUT  │
    ┌──────────────────────────┐  ⟋S560            │   STABILITY EVALUATION │
    │    DETERMINE THAT THERE IS │                  │  RESULT INDICATING THAT│
    │  POSSIBILITY THAT POWER LINE│                 │   POWER LINE IS STABLE │
    │     BECOMES UNSTABLE       │                  └──────────────────────┘
    └──────────────────────────┘                               │
                    │                                           │
                    ▼                                           │
    ┌──────────────────────────┐  ⟋S570                         │
    │    OUTPUT CONTROL COMMAND  │                              │
    │  FOR CHANGING OUTPUT POWER │                              │
    └──────────────────────────┘                               │
                    │                                           │
                    ▼                                           │
               ┌─────────┐◀───────────────────────────────────┘
               │   END   │
               └─────────┘
```

[FIG. 6]

# FIG. 6

POWER LINE ~210

235

CENTRAL FEED COMMAND CENTER ~230

POWER LINE MANAGEMENT DEVICE 240

POWER INFORMATION ACQUISITION UNIT 254

STABILITY EVALUATION UNIT 256

POWER LOAD PREDICTION INFORMATION ~262

POWER GENERATION PREDICTION INFORMATION ~264

STABILITY INDEX CALCULATION UNIT 252

STABILITY INDEX INFORMATION ~269

STABILITY SIMULATION MODEL ~605

STABILITY SIMULATION PROGRAM ~610

SIMULATION RESULT FOR EACH OF PLURALITY OF STABILITY INDEXES ~615

[FIG. 7]

# FIG. 7

STABILITY INDEX 269

| STABILITY INDEX 710 | STABILITY 720 |
|---|---|
| k1 | STABLE |
| k2 | UNSTABLE |
| ⋮ | ⋮ |
| kn | UNSTABLE |

[FIG. 8]

# FIG. 8

## STABILITY INDEX INFORMATION GENERATION PROCESSING 800

```
                      START

             SET STABILITY INDEX          S810
                  k = k1

                   GENERATE
          STABILITY SIMULATION MODEL      S815
                 OF POWER LINE

k = k+1      SET PARAMETERS OF            S820
             SIMULATION MODEL

              PERFORM SIMULATION          S825
              BY USING STABILITY
             SIMULATION PROGRAM

                   ANALYZE                S830
               VOLTAGE WAVEFORM                    Yes
               (SSO DETECTION)

           No  S850                                        S835
      DETECT ABSENCE OF SSO          DETECT OCCURRENCE OF SSO

                   S855                                    S840
          DETERMINE THAT             DETERMINE THAT STABILITY
     STABILITY INDEX k IS STABLE       INDEX k IS UNSTABLE

                   S860                                    S845
         IN STABILITY INDEX             IN STABILITY INDEX
     INFORMATION, THE STABILITY     INFORMATION, THE STABILITY
      INDEX k IS SET TO "STABLE"    INDEX k1 IS SET TO "UNSTABLE"

                     k < n ?                        S865

                      END
```

[FIG. 9]

# FIG. 9

VOLTAGE WAVEFORM 900
(CASE OF PES POWER USAGE RATE = k1)

VOLTAGE
(MV)

TIME (s)

[FIG. 10]

# FIG. 10

VOLTAGE WAVEFORM 1000
(CASE OF PES POWER USAGE RATE = k2)

VOLTAGE
(MV)

TIME (s)

[FIG. 11]

# FIG. 11

## STABILITY EVALUATION RESULT SCREEN 1100

| RE | PES POWER USAGE RATE | STABILITY |
|---|---|---|
| AREA 1 | 30 | UNSTABLE |
| | 20 | UNSTABLE |
| | 15 | STABLE |
| AREA 2 | 20 | UNSTABLE |
| | 12 | STABLE |
| AREA 3 | 15 | UNSTABLE |
| | 12 | STABLE |

## INTERNATIONAL SEARCH REPORT

| International application No. |
|---|
| **PCT/JP2023/041112** |

### A. CLASSIFICATION OF SUBJECT MATTER

*H02J 3/00*(2006.01)i; *H02J 3/38*(2006.01)i; *H02J 13/00*(2006.01)i
FI:   H02J3/00 170; H02J3/00 130; H02J3/38 110; H02J13/00 301A

According to International Patent Classification (IPC) or to both national classification and IPC

### B. FIELDS SEARCHED

Minimum documentation searched (classification system followed by classification symbols)

H02J3/00; H02J3/38; H02J13/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2016-208654 A (HITACHI, LTD.) 08 December 2016 (2016-12-08) | 1, 2, 6 |
| | paragraphs [0001]-[0251], fig. 1-43 | |
| A | | 3-5, 7 |
| A | WO 2019/150586 A1 (MITSUBISHI ELECTRIC CORPORATION) 08 August 2019 (2019-08-08) | 1-7 |
| | entire text, all drawings | |
| A | WO 2018/150461 A1 (MITSUBISHI ELECTRIC CORPORATION) 23 August 2018 (2018-08-23) | 1-7 |
| | entire text, all drawings | |
| A | JP 2023-038109 A (HITACHI, LTD.) 16 March 2023 (2023-03-16) | 1-7 |
| | entire text, all drawings | |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 January 2024** | **06 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2023/041112**

| Patent document cited in search report | | | Publication date (day/month/year) | Patent family member(s) | | | Publication date (day/month/year) |
|---|---|---|---|---|---|---|---|
| JP | 2016-208654 | A | 08 December 2016 | US | 2018/0152020 | A1 | |
| | | | | paragraphs [0001]-[0278], fig. 1-43 | | | |
| | | | | WO | 2016/170912 | A1 | |
| | | | | EP | 3288142 | A1 | |
| WO | 2019/150586 | A1 | 08 August 2019 | US | 2021/0064073 | A1 | |
| | | | | entire text, all drawings | | | |
| WO | 2018/150461 | A1 | 23 August 2018 | US | 2020/0021132 | A1 | |
| | | | | entire text, all drawings | | | |
| JP | 2023-038109 | A | 16 March 2023 | WO | 2023/032554 | A1 | |

Form PCT/ISA/210 (patent family annex) (July 2022)

**REFERENCES CITED IN THE DESCRIPTION**

**Patent documents cited in the description**

- US 10855079 B